(19) Europäisches Patentamt
European Patent Office
Office européen des brevets

(11) **EP 4 707 822 A1**

(12) **EUROPEAN PATENT APPLICATION**

(43) Date of publication:
**11.03.2026 Bulletin 2026/11**

(21) Application number: **25197680.9**

(22) Date of filing: **22.08.2025**

(51) International Patent Classification (IPC):
**G01R 23/16** (2006.01)   **G01R 35/00** (2006.01)
**G01R 31/62** (2020.01)

(52) Cooperative Patent Classification (CPC):
**G01R 23/16; G01R 31/62; G01R 35/005**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **27.08.2024 CN 202411188366**

(71) Applicant: **Siemens Aktiengesellschaft**
**80333 München (DE)**

(72) Inventors:
• ZHAO, Shu Yao
  **Nanjing, Jiangsu Province, 211100 (CN)**
• CAO, Qi
  **Nanjing, Jiangsu Province, 211101 (CN)**
• WANG, Qian
  **Chongqing, 400000 (CN)**
• SUN, Xuan
  **Nanjing, 211100 (CN)**

(74) Representative: **HKW Intellectual Property PartG mbB**
**Theresienhöhe 12**
**80339 München (DE)**

(54) **ELECTRONIC TRANSFORMER CALIBRATION METHOD AND APPARATUS**

(57)    This application provides an electronic transformer calibration method and apparatus. The electronic transformer calibration method includes: obtaining amplitudes and phase angles of sampled signals obtained by a tested signal acquisition unit by sampling different frequency signals, where the tested signal acquisition unit is a signal acquisition unit included in a to-be-calibrated electronic transformer; determining an amplitude gain factor and a time constant of the tested signal acquisition unit based on the amplitudes and the phase angles; determining a dominant pole and an amplitude factor of the tested signal acquisition unit based on the amplitude gain factor and the time constant; and configuring the dominant pole and the amplitude factor for a digital signal processing unit included in the to-be-calibrated electronic transformer, so that the digital signal processing unit performs digital filtering on an input signal based on the dominant pole and the amplitude factor, to obtain an output signal, where the input signal is obtained by performing analog-to-digital conversion on a signal output by the tested signal acquisition unit. According to this solution, measurement precision of the calibrated electronic transformer can be improved.

FIG. 2

EP 4 707 822 A1

**Description**

TECHNICAL FIELD

This application relates to the field of electronic information technologies, and in particular, to an electronic transformer calibration method and apparatus.

BACKGROUND

An electronic transformer is an advanced measurement device for a power system. It measures electrical parameters such as a current, a voltage, and power using an electronic technology and an electromagnetic induction principle. The electronic transformer includes an induction unit, a signal acquisition unit, an analog-to-digital conversion unit, a digital signal processing unit, and the like. The induction unit generates an induction signal based on a to-be-measured current or voltage. The signal acquisition unit samples the induction signal to obtain a sampled signal, and transmits the sampled signal to the analog-to-digital conversion unit. The analog-to-digital conversion unit converts the sampled signal into a digital signal, and then sends the digital signal to the digital signal processing unit. The digital signal processing unit calculates a measured current or voltage based on the digital signal. The induction unit and the signal acquisition unit form an analog signal transmission system. The signal acquisition unit includes a component such as a capacitor and a resistor. The digital signal processing unit calculates a cut-off frequency of the analog signal transmission system based on a nominal value of the component in the signal acquisition unit, and calculates the measured current or voltage based on the cut-off frequency. However, since there is a deviation between actual capacitance or resistance and the nominal value of the component in the signal acquisition unit, there is a deviation between the calculated cut-off frequency and an actual cut-off frequency, resulting in a large error of the measured current or voltage.

Currently, a same clock source signal and a same current or voltage input signal are used for a tested electronic transformer and a standard transformer, digital output signals of the standard transformer and the tested electronic transformer are acquired, an amplitude error and a phase error are calculated based on the acquired digital output signals, and a cut-off frequency is further calculated based on the amplitude error and the phase error.

However, an existing method for calibrating a cut-off frequency of an electronic transformer is only suitable for calculating an amplitude error and a phase error at a specific operating frequency, and cannot meet a requirement for measurement precision in a wide frequency range.

SUMMARY

In view of this, embodiments of this application provide an electronic transformer calibration method and apparatus, an electronic device, and a storage medium, to improve measurement precision of an electronic transformer in a wide operating frequency range.

According to a first aspect of the embodiments of this application, an electronic transformer calibration method is provided. The method includes: obtaining amplitudes and phase angles of sampled signals obtained by a tested signal acquisition unit by sampling different frequency signals, where the tested signal acquisition unit is a signal acquisition unit included in a to-be-calibrated electronic transformer; determining an amplitude gain factor and a time constant of the tested signal acquisition unit based on the amplitudes and the phase angles; determining a dominant pole and an amplitude factor of the tested signal acquisition unit based on the amplitude gain factor and the time constant; and configuring the dominant pole and the amplitude factor for a digital signal processing unit included in the to-be-calibrated electronic transformer, so that the digital signal processing unit performs digital filtering on an input signal based on the dominant pole and the amplitude factor, to obtain an output signal, where the input signal is obtained by performing analog-to-digital conversion on a signal output by the tested signal acquisition unit.

In a possible implementation, the obtaining amplitudes and phase angles of sampled signals obtained by a tested signal acquisition unit by sampling different frequency signals includes: inputting a test signal generated by a signal generation apparatus separately into the tested signal acquisition unit and a reference signal acquisition unit; sampling the test signal at a plurality of different frequency points of the test signal via the tested signal acquisition unit and the reference signal acquisition unit, to obtain a plurality of first sampled signals acquired by the tested signal acquisition unit and a plurality of second sampled signals acquired by the reference signal acquisition unit; and determining, based on the first sampled signal and the second sampled signal that correspond to a same frequency point, an amplitude and a phase angle of the first sampled signal.

In a possible implementation, frequency values corresponding to the plurality of frequency points are located within a range of 1 Hz to 80 Hz.

In a possible implementation, the determining an amplitude gain factor and a time constant of the tested signal acquisition unit based on the amplitudes and the phase angles includes: constructing a target function according to a least squares method, where a variable of the target function includes the amplitude gain factor and the time constant of the tested signal acquisition unit, and a constant of the target function includes the amplitudes and the phase angles of the sampled signals obtained by the tested signal acquisition unit through sampling; and solving the target function to obtain the amplitude gain factor and the time constant of the tested signal acquisition unit.

In a possible implementation, the target function includes: $y(T, M) = \sum_{k=1}^{N} \left| \frac{M}{1+j2\pi f_k T} - A_k e^{j\theta_k} \right|^2$. N is used to represent a quantity of the frequency points, and j is used to represent an imaginary number. $f_k$ is used to represent a frequency value corresponding to a $k^{th}$ frequency point. $A_k$ is used to represent an amplitude of a sampled signal obtained by the tested signal acquisition unit by sampling the test signal at the $k^{th}$ frequency point. $\theta_k$ is used to represent a phase angle of the sampled signal obtained by the tested signal acquisition unit by sampling the test signal at the $k^{th}$ frequency point. $e$ is used to represent a natural constant. M is used to represent the amplitude gain factor. T is used to represent the time constant.

In a possible implementation, the determining a dominant pole and an amplitude factor of the tested signal acquisition unit based on the amplitude gain factor and the time constant includes: determining a cut-off frequency of a filter in the tested signal acquisition unit based on the time constant; determining actual capacitance of a capacitor in the filter based on the cut-off frequency of the filter; updating a signal transmission model with the actual capacitance, and performing pole-zero analysis on the signal transmission model to obtain the dominant pole of the tested signal acquisition unit, where the signal transmission model is obtained by modeling an analog signal transmission system, the analog signal transmission system including an induction unit and the tested signal acquisition unit in the to-be-calibrated electronic transformer; and transforming the amplitude gain factor to obtain the amplitude factor of the tested signal acquisition unit.

In a possible implementation, the configuring the dominant pole and the amplitude factor for a digital signal processing unit included in the to-be-calibrated electronic transformer includes: constructing an analog filter based on the dominant pole and the amplitude factor; performing bilinear transformation on the analog filter to obtain an intermediate digital filter; and converting the intermediate digital filter into a difference equation to obtain a digital filter, where the digital filter is configured to perform digital filtering on the input signal to obtain the output signal.

In a possible implementation, the analog filter includes: $H_{corr}(s) = \frac{1}{K} \cdot \frac{(s-p_{1\_new})}{(s-p_k)}$.

The intermediate digital filter includes: $H_{corr}(z^{-1}) = \frac{1}{K} \cdot \frac{b_1 z^{-1} + b_0}{a_1 z^{-1} + 1}$. The digital filter includes:

$y[n] = \frac{1}{K} \cdot (b_0 \cdot x[n] + b_1 \cdot x[n-1]) - a_1 \cdot y[n-1]$. $H_{corr}$(s) is used to represent the analog filter. s is used to represent a complex frequency domain. $p_{1\_new}$ is used to represent the dominant pole. $p_k$ is used to represent a $k^{th}$ pole. $K$ is used to represent the amplitude factor. $H_{corr}(z^{-1})$ is used to represent the intermediate digital filter. z is used to represent a zero. $b_1 = \frac{1-2f_s \cdot T_{1\_new}}{1+2f_s \cdot T_k} \cdot \frac{T_k}{T_{1\_new}}$. $b_0 = \frac{1+2f_s \cdot T_{1\_new}}{1+2f_s \cdot T_k} \cdot \frac{T_k}{T_{1\_new}}$. $a_1 = \frac{1-2f_s \cdot T_k}{1+2f_s \cdot T_k}$. $T_{1\_new} = \frac{1}{|p_{1\_new}|}$. $T_k$ is a constant. $f_s$ is a sampling frequency of the tested signal acquisition unit. $y[n]$ is used to represent an output signal of the digital filter at a current sampling point. $y[n - 1]$ is used to represent an output signal of the digital filter at a previous sampling point. $x[n]$ is an input signal of the digital filter at the current sampling point. $x[n - 1]$ is an input signal of the digital filter at the previous sampling point.

According to a second aspect of the embodiments of this application, an electronic transformer calibration apparatus is provided. The apparatus includes: an obtaining module, configured to obtain amplitudes and phase angles of sampled signals obtained by a tested signal acquisition unit by sampling different frequency signals, where the tested signal acquisition unit is a signal acquisition unit included in a to-be-calibrated electronic transformer; a first calculation module, configured to determine an amplitude gain factor and a time constant of the tested signal acquisition unit based on the amplitudes and the phase angles; a second calculation module, configured to determine a dominant pole and an amplitude factor of the tested signal acquisition unit based on the amplitude gain factor and the time constant; and a configuration module, configured to configure the dominant pole and the amplitude factor for a digital signal processing unit included in the to-be-calibrated electronic transformer, so that the digital signal processing unit performs digital filtering on an input signal based on the dominant pole and the amplitude factor, to obtain an output signal, where the input signal is obtained by performing analog-to-digital conversion on a signal output by the tested signal acquisition unit.

In a possible implementation, the obtaining module includes: an input submodule, configured to input a test signal generated by a signal generation apparatus separately into the tested signal acquisition unit and a reference signal acquisition unit; a sampling submodule, configured to sample the test signal at a plurality of different frequency points of the test signal via the tested signal acquisition unit and the reference signal acquisition unit, to obtain a plurality of first sampled signals acquired by the tested signal acquisition unit and a plurality of second sampled signals acquired by the reference signal acquisition unit; and an operation submodule, configured to determine, based on the first sampled signal and the second sampled signal that correspond to a same frequency point, an amplitude and a phase angle of the first sampled signal. In a possible implementation, frequency values corresponding to the plurality of frequency points are located within a range of 1 Hz to 80 Hz.

In a possible implementation, the first calculation module is configured to construct a target function according to a least squares method, and solve the target function to obtain the amplitude gain factor and the time constant of the tested signal acquisition unit, where a variable of the target function includes the amplitude gain factor and the time constant of the tested signal acquisition unit, and a constant of the target function includes the amplitudes and the phase angles of the sampled signals obtained by the tested signal acquisition unit through sampling.

In a possible implementation, the target function includes: $y(T, M) = \sum_{k=1}^{N} \left| \frac{M}{1+j2\pi f_k T} - A_k e^{j\theta_k} \right|^2$ . N is used to represent a quantity of the frequency points, and j is used to represent an imaginary number. $f_k$ is used to represent a frequency value corresponding to a $k^{th}$ frequency point. $A_k$ is used to represent an amplitude of a sampled signal obtained by the tested signal acquisition unit by sampling the test signal at the $k^{th}$ frequency point. $\theta_k$ is used to represent a phase angle of the sampled signal obtained by the tested signal acquisition unit by sampling the test signal at the $k^{th}$ frequency point. e is used to represent a natural constant. M is used to represent the amplitude gain factor. T is used to represent the time constant.

In a possible implementation, the second calculation module includes: a first construction submodule, configured to determine a cut-off frequency of a filter in the tested signal acquisition unit based on the time constant; a second calculation submodule, configured to determine actual capacitance of a capacitor in the filter based on the cut-off frequency of the filter; an analysis submodule, configured to update a signal transmission model with the actual capacitance, and perform pole-zero analysis on the signal transmission model to obtain the dominant pole of the tested signal acquisition unit, where the signal transmission model is obtained by modeling an analog signal transmission system, the analog signal transmission system including an induction unit and the tested signal acquisition unit in the to-be-calibrated electronic transformer; and a first transformation submodule, configured to transform the amplitude gain factor to obtain the amplitude factor of the tested signal acquisition unit.

In a possible implementation, the configuration module includes: a second construction submodule, configured to construct an analog filter based on the dominant pole and the amplitude factor; a second transformation submodule, configured to perform bilinear transformation on the analog filter to obtain an intermediate digital filter; and a conversion submodule, configured to convert the intermediate digital filter into a difference equation to obtain a digital filter, where the digital filter is configured to perform digital filtering on the input signal to obtain the output signal.

In a possible implementation, the analog filter includes: $H_{corr}(s) = \frac{1}{K} \cdot \frac{(s-p_{1\_new})}{(s-p_k)}$ .

The intermediate digital filter includes: $H_{corr}(z^{-1}) = \frac{1}{K} \cdot \frac{b_1 z^{-1} + b_0}{a_1 z^{-1} + 1}$ . The digital filter includes: $y[n] = \frac{1}{K} \cdot (b_0 \cdot x[n] + b_1 \cdot x[n-1]) - a_1 \cdot y[n-1]$ . $H_{corr}(s)$ is used to represent the analog filter. s is used to represent a complex frequency domain. $p_{1\_new}$ is used to represent the dominant pole. $p_k$ is used to represent a $k^{th}$ pole. K is used to represent the amplitude factor. $H_{corr}(z^{-1})$ is used to represent the intermediate digital filter. z is used to represent a zero. $b_1 = \frac{1-2f_s \cdot T_{1\_new}}{1+2f_s \cdot T_k} \cdot \frac{T_k}{T_{1\_new}}$ . $b_0 = \frac{1+2f_s \cdot T_{1\_new}}{1+2f_s \cdot T_k} \cdot \frac{T_k}{T_{1\_new}}$ . $a_1 = \frac{1-2f_s \cdot T_k}{1+2f_s \cdot T_k}$ .

$T_{1\_new} = \frac{1}{|p_{1\_new}|}$ . $T_k$ is a constant. $f_s$ is a sampling frequency of the tested signal acquisition unit. $y[n]$ is used to represent an output signal of the digital filter at a current sampling point. $y[n-1]$ is used to represent an output signal of the digital filter at a previous sampling point. $x[n]$ is an input signal of the digital filter at the current sampling point. $x[n-1]$ is an input signal of the digital filter at the previous sampling point.

According to a third aspect of the embodiments of this application, an electronic transformer calibration apparatus is provided. The apparatus includes: at least one memory, configured to store instructions; and at least one processor, configured to perform, according to the instructions stored in the memory, the electronic transformer calibration method provided in any one of the first aspect or the possible implementations of the first aspect.

According to a fourth aspect of the embodiments of this application, a computer-readable storage medium is provided. The computer-readable storage medium has computer instructions stored thereon. The computer instructions, when executed by a processor, cause the processor to perform the electronic transformer calibration method provided in any one of the first aspect or the possible implementations of the first aspect.

It can be learned from the foregoing technical solutions that after the amplitudes and the phase angles of the sampled signals of different frequencies acquired by the tested signal acquisition unit are obtained, the amplitude gain factor and the time constant are determined based on the amplitudes and the phase angles, the dominant pole and the amplitude factor are further determined based on the amplitude gain factor and the time constant, and then the dominant pole and the amplitude factor are configured for the digital signal processing unit, so that the digital signal processing unit performs digital filtering on the input signal based on the dominant pole and the amplitude factor, to obtain the output signal that can indicate a measured primary current or voltage. Since the time constant has a linear relationship with an actual cut-off frequency of the tested signal acquisition unit, after the dominant pole and the amplitude factor determined based on the amplitude gain factor and the time constant are configured for the digital signal processing unit, the digital signal processing unit can calculate the measured primary current or voltage based on the actual cut-off frequency of the tested signal acquisition unit, ensuring measurement precision of the electronic transformer. The time constant and the amplitude gain factor are determined based on the amplitudes and the phase angles of the sampled signals of different frequencies, so that the dominant pole and the amplitude factor are adapted to a wide operating frequency range, ensuring the measurement precision of the electronic transformer in measuring different frequencies and primary currents or voltages.

The electronic transformer calibration solution provided in the embodiments of this application does not need to consider a clock synchronization problem of signals, features a simple system configuration, and reduces costs. A cut-off frequency of the analog signal transmission system is calibrated, so that impact of an analog component on the measurement precision of the electronic transformer within an allowable error range is corrected, and the signal transmission model is corrected, making an output of a digital filter in the digital signal processing unit match an actual measurement system. Therefore, the measurement precision of the electronic transformer in a wide frequency range (for example, 10 Hz to 80 Hz) can be effectively improved, to meet a requirement of a precision class 0.2.

BRIEF DESCRIPTION OF THE DRAWINGS

FIG. 1 is a schematic diagram of an exemplary system applied to an embodiment of this application;

FIG. 2 is a flowchart of an electronic transformer calibration method according to an embodiment of this application;

FIG. 3 is a flowchart of an amplitude and phase angle obtaining method according to an embodiment of this application;

FIG. 4 is a flowchart of a target function solving method according to an embodiment of this application;

FIG. 5 is a flowchart of a dominant pole and amplitude factor determining method according to an embodiment of this application;

FIG. 6 is a schematic diagram of a first-order RC filter according to an embodiment of this application;

FIG. 7 is a flowchart of a digital signal processing unit configuration method according to an embodiment of this application;

FIG. 8 is a schematic diagram of an electronic transformer calibration apparatus according to an embodiment of this application;

FIG. 9 is a schematic diagram of an electronic transformer calibration apparatus according to another embodiment of this application;

FIG. 10 is a schematic diagram of an electronic transformer calibration apparatus according to still another embodiment of this application;

FIG. 11 is a schematic diagram of an electronic transformer calibration apparatus according to still yet another embodiment of this application; and

FIG. 12 is a schematic diagram of an electronic transformer calibration apparatus including a memory and a processor according to this application.

List of reference numerals:

| 10: | Electronic transformer | 11: | Induction unit | 12: | Signal acquisition unit |
| --- | --- | --- | --- | --- | --- |
| 13: | Analog-to-digital conversion unit | 14: | Digital signal processing unit | 200: | Electronic transformercalibration method |
| 201to 204: | Method steps | 300: | Amplitude and phase angle obtaining method | 301to 303: | Method steps |
| 400: | Target function solving method | 401to 418: | Method steps | 501to 504: | Method steps |
| 500: | Dominant pole and amplitude factor determining method | | 700: Digital signal processing unit configuration method | | |
| 800: | Electronic transformer calibration apparatus | 801: | Obtaining module | 802: | First calculation module |
| 803: | Second calculation module | 804: | Configuration module | 8011: | Input submodule |
| 8012: | Sampling submodule | 8013: | Operation submodule | 8031: | First construction submodule |
| 8032: | First calculation submodule | 8033: | Analysis submodule | 8034: | First transformation module |
| 8041: | Second construction submodule | 8042: | Second transformation submodule | 8043: | Conversion submodule |
| 1200: | Electronic transformer calibration apparatus | 1201: | Memory | 1202: | Processor |
| 701to 703: | Method steps | | | | |

## DETAILED DESCRIPTION

To make a person skilled in the art understand the technical solutions in the embodiments of this application better, the following clearly and completely describes the technical solutions in the embodiments of this application with reference to the accompanying drawings in the embodiments of this application.

Apparently, the described embodiments are merely some but not all of the embodiments of this application. All other embodiments obtained by a person of ordinary skill in the art based on the embodiments of this application shall fall within the protection scope of the embodiments of this application.

The terms used in this application are for the purpose of describing specific embodiments only and are not intended to limit this application. The singular forms of "a", "the", and "this" used in this application and the appended claims are intended to include the plural forms as well, unless the context clearly indicates otherwise. It should be further understood that the term "and/or" used herein indicates and includes any or all possible combinations of one or more associated listed items. In this patent application, nouns and pronouns related to persons are not limited to specific genders.

It should be understood that although the terms such as "first" "second" and "third" may be used in this application to describe various information, the information should not be limited to these terms. These terms are merely used to distinguish between information of the same type. For example, without departing from the scope of this application, first information may also be referred to as second information, and similarly, second information may also be referred to as first information. Depending on the context, for example, the word "if" used herein may be interpreted as "while", "when", or "in response to determining".

To make the objectives, technical solutions, and advantages of this application clearer, the following further describes implementations of this application in detail with reference to the accompanying drawings.

Exemplary system

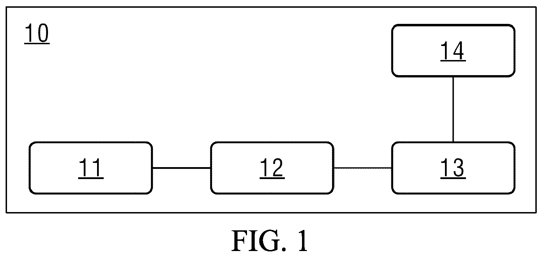

FIG. 1 shows an exemplary system applicable to an electronic transformer calibration method according to an embodiment of this application. As shown in FIG. 1, an electronic transformer 10 includes an induction unit 11, a signal acquisition unit 12, an analog-to-digital conversion unit 13, and a digital signal processing unit 14. The electronic transformer 10 may be an electronic current transformer using a Rogowski (Rogowski) coil as a sensing element or an electronic voltage transformer represented by a capacitive voltage division type.

The induction unit 11 is configured to detect a current or a voltage. For example, the induction unit 11 may detect the current based on a Rogowski (Rogowski) coil, or may detect the voltage through capacitive voltage division. The electronic transformer may be configured to detect a current or a voltage of a target device. The signal acquisition unit 12 may sample the current or the voltage detected by the induction unit 11 to obtain an analog signal, and send the obtained analog signal to the analog-to-digital conversion unit 13. The analog-to-digital conversion unit 13 performs analog-to-digital conversion on the analog signal sent by the signal acquisition unit 12, and sends a digital signal obtained through conversion to the digital signal processing unit 14. In an example for description, the digital signal processing unit 14 serves as a control core of the electronic transformer 10, and is responsible for implementing acquisition, processing, and output of data. The digital signal processing unit 14 may send a processed digital signal to a merging unit. The merging unit may merge and synchronize current and voltage data from a plurality of electronic transformers 10, and forward processed digital signals in a specific format to a bay-level device for use. The bay-level device may implement a protection and control function for a primary device, acquisition and summarization of real-time data information, an operation lockout function, issuing of a control command, and accomplishment of tasks such as communication with a process level and a station level.

An analog signal transmission system includes the induction unit 11 and the signal acquisition unit 12. The signal acquisition unit 12 includes an amplification circuit, a filter circuit, and the like. Signal equivalent model analysis is performed on the analog signal transmission system to obtain a pole-zero expression of a transfer function of the analog signal transmission system: $G(s) = K \cdot \dfrac{(s-z_1)(s-z_2)\cdots(s-z_m)}{(s-p_1)(s-p_2)\cdots(s-p_n)}$, where $z_1$ to $z_m$ are zeros (zeros), $p_1$ to $p_n$ are poles (poles), K is a gain factor, and s represents an s domain (also referred to as a complex frequency domain). The signal acquisition unit 12 includes a filter, configured to limit a frequency characteristic range of the electronic transformer 10 to several hundreds hertz. A cut-off frequency (cut-off frequency) of the filter is to be a cut-off frequency corresponding to a dominant pole $p_1$ of the analog signal transmission system. In the digital signal processing unit 14, the cut-off frequency may be used to calculate a measured primary current or voltage. Therefore, a deviation in the cut-off frequency of the filter may affect measurement precision of the electronic transformer 10 within a normal operating frequency range. The dominant pole (dominant pole) herein means playing a dominant role in system response.

There is a deviation between actual resistance or capacitance and a nominal value of an analog circuit component in the signal acquisition unit 12. For a resistive component with an allowable error range of 0.1%, a deviation in resistance of the resistive component may cause an error of approximately 0.17% to the cut-off frequency. For a resistive component with an allowable error range of 10%, a deviation in resistance of the resistive component may cause an error of approximately 5% of the cut-off frequency. It can be learned that there is a difference between a cut-off frequency of the analog signal transmission system calculated by the digital signal processing unit 14 based on the nominal value of the component and an actual cut-off frequency of the analog signal transmission system, introducing a measurement error to the electronic transformer. A larger difference between the actual cut-off frequency and the theoretically calculated cut-off frequency indicates a larger measurement error of the measured current or voltage.

Therefore, it is necessary to calibrate the cut-off frequency of the analog signal transmission system. A calibrated cut-off frequency is used in calculation of a digital filter in the digital signal processing unit 14, to improve the measurement precision of the electronic transformer 10.

Electronic transformer calibration method

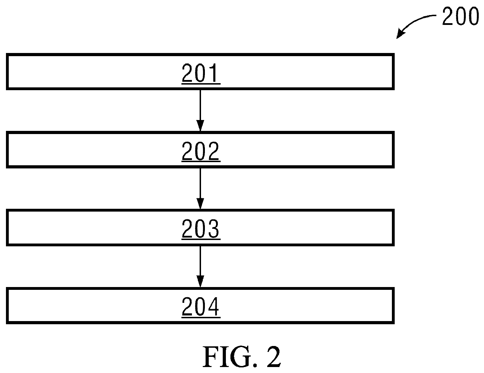

Based on the foregoing system, an embodiment of this application provides an electronic transformer calibration method. The calibration method is performed by an electronic transformer calibration apparatus. FIG. 2 is a flowchart of an electronic transformer calibration method 200. As shown in FIG. 2, the electronic transformer calibration method 200 includes the following steps.

Step 201: Obtain amplitudes and phase angles of sampled signals obtained by a tested signal acquisition unit by sampling different frequency signals.

The tested signal acquisition unit is a signal acquisition unit 12 in a to-be-calibrated electronic transformer. The tested signal acquisition unit samples a variable frequency signal, so that the amplitudes and the phase angles of the sampled signals obtained by the tested signal acquisition unit by sampling different frequency signals may be obtained.

Step 202: Determine an amplitude gain factor and a time constant of the tested signal acquisition unit based on the amplitudes and the phase angles.

The amplitude gain factor (amplitude gain factor) and the time constant of the tested signal acquisition unit may be determined based on amplitudes and phase angles of a plurality of sampled signals corresponding to different frequencies. The amplitude gain factor is a factor by which the amplitude of the sampled signal obtained through the signal acquisition unit 12 increases or decreases. The amplitude gain factor of the tested signal acquisition unit affects the amplitude of the signal acquired by the tested signal acquisition unit. The time constant of the tested signal acquisition unit and an actual cut-off frequency of the tested signal acquisition unit satisfy the following relationship:

$$T = \frac{1}{2\pi f_c}$$

$T$ is used to represent the time constant of the tested signal acquisition unit. $f_c$ is used to represent the actual cut-off frequency of the tested signal acquisition unit. $\pi$ is used to represent the circumference ratio.

Step 203: Determine a dominant pole and an amplitude factor of the tested signal acquisition unit based on the amplitude gain factor and the time constant.

The dominant pole and the amplitude factor of the tested signal acquisition unit may be determined based on the amplitude gain factor and the time constant of the tested signal acquisition unit. The dominant pole of the tested signal acquisition unit may be determined based on a circuit structure of a filter in the tested signal acquisition unit and the time constant. The amplitude factor and the amplitude gain factor of the tested signal acquisition unit have a specific mathematical relationship, so that the amplitude factor may be determined based on the amplitude gain factor.

Step 204: Configure the dominant pole and the amplitude factor for a digital signal processing unit included in the to-be-calibrated electronic transformer, so that the digital signal processing unit performs digital filtering on an input signal based on the dominant pole and the amplitude factor, to obtain an output signal, where the input signal is obtained by performing analog-to-digital conversion on a signal output by the tested signal acquisition unit.

After the dominant pole and the amplitude factor of the tested signal acquisition unit are obtained, the dominant pole and the amplitude factor may be configured for the digital signal processing unit included in the to-be-calibrated electronic transformer, so that the digital signal processing unit may perform digital filtering on the input signal based on the dominant pole and the amplitude factor, to obtain the output signal. In the to-be-calibrated electronic transformer, the input signal of the digital signal processing unit is a digital signal obtained by an analog-to-digital conversion unit by performing analog-to-digital conversion on an analog signal acquired by the tested signal acquisition unit, and the output signal of the digital signal processing unit may indicate a measured primary current or voltage.

In this embodiment of this application, after the amplitudes and the phase angles of the sampled signals of different frequencies acquired by the tested signal acquisition unit are obtained, the amplitude gain factor and the time constant are determined based on the amplitudes and the phase angles, the dominant pole and the amplitude factor are further determined based on the amplitude gain factor and the time constant, and then the dominant pole and the amplitude factor are configured for the digital signal processing unit, so that the digital signal processing unit performs digital filtering on the input signal based on the dominant pole and the amplitude factor, to obtain the output signal that can indicate the measured primary current or voltage. Since the time constant has a linear relationship with the actual cut-off frequency of the tested signal acquisition unit, after the dominant pole and the amplitude factor determined based on the amplitude gain factor and the time constant are configured for the digital signal processing unit, the digital signal processing unit can calculate the measured primary current or voltage based on the actual cut-off frequency of the tested signal acquisition unit, ensuring the measurement precision of the electronic transformer. The time constant and the amplitude gain factor are determined based on the amplitudes and the phase angles of the sampled signals of different frequencies, so that the dominant pole and the amplitude factor are adapted to a wide operating frequency range, ensuring the measurement precision of the electronic transformer in measuring different frequencies and primary currents or voltages.

In a possible implementation, to obtain the amplitudes and the phase angles of the sampled signals of different frequencies acquired by the tested signal acquisition unit, the variable frequency signal may be sampled via both the tested signal acquisition unit and a reference signal acquisition unit, and then the amplitudes and the phase angles of the sampled signals acquired by the tested signal acquisition unit are determined based on the sampled signals acquired by the tested signal acquisition unit and sampled signals acquired by the reference signal acquisition unit.

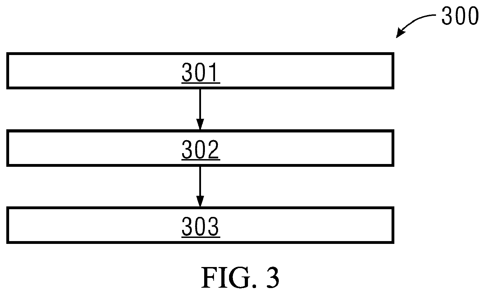

FIG. 3 is a flowchart of an amplitude and phase angle obtaining method 300 according to an embodiment of this application. As shown in FIG. 3, the amplitude and phase angle obtaining method 300 includes the following steps.

Step 301: Input a test signal generated by a signal generation apparatus separately into the tested signal acquisition unit and the reference signal acquisition unit.

Parameters used by the reference signal acquisition unit to determine phase angles are known, and phase angles of the sampled signals acquired by the reference signal acquisition unit may be determined based on these parameters.

The test signal generated by the signal generation apparatus is injected into both the tested signal acquisition unit and the reference signal acquisition unit, so that the tested signal acquisition unit and the reference signal acquisition unit may sample the same signal separately.

In an example, the signal generation apparatus may generate a signal of a frequency ranging from 0 to 1000 Hz. When the electronic transformer is calibrated, the signal generation apparatus may generate the test signal of a frequency ranging from 1 Hz to 80 Hz, so that the tested signal acquisition unit may acquire sampled signals corresponding to frequencies ranging from 1 Hz to 80 Hz. Therefore, the frequencies of the sampled signals cover a large frequency range, ensuring high measurement precision of the electronic transformer within a wide operating frequency range after the electronic transformer is calibrated based on the amplitudes and the phase angles of the sampled signals. The frequency range of 1 Hz to 80 Hz covers a common operating frequency of the electronic transformer, ensuring high measurement precision of the electronic transformer in different measurement systems.

Step 302: Obtain a plurality of first sampled signals acquired by the tested signal acquisition unit and a plurality of second sampled signals acquired by the reference signal acquisition unit, where the first sampled signals and the second sampled signals are obtained by sampling the test signal at a plurality of different frequency points of the test signal via the tested signal acquisition unit and the reference signal acquisition unit.

The plurality of frequency points are predetermined within the frequency range of the test signal. Different frequency points correspond to different frequencies. The test signal is sampled at each frequency point via the tested signal acquisition unit and the reference signal acquisition unit, where the tested signal acquisition unit obtains the first sampled signals through sampling, and the reference signal acquisition unit obtains the second sampled signals through sampling.

In an example, the frequency range of the test signal is 1 Hz to 80 Hz. 10 frequency points are determined within the frequency range, and the test signal is sampled at each frequency point via the tested signal acquisition unit and the reference signal acquisition unit, where the tested signal acquisition unit obtains 10 first sampled signals through sampling, and the reference signal acquisition unit obtains 10 second sampled signals through sampling.

In an example, the plurality of frequency points may be uniformly distributed within the frequency range of the test signal. For example, starting from a lower limit of the frequency range, one frequency point is determined at an interval of one frequency width threshold. In another example, the plurality of frequency points are non-uniformly distributed within the frequency range of the test signal. For example, many frequency points are distributed near 50 Hz and/or 60 Hz, to ensure measurement accuracy of the electronic transformer for common currents or voltages of the frequencies of 50 Hz and 60 Hz.

Step 303: Determine, based on the first sampled signal and the second sampled signal that correspond to a same frequency point, an amplitude and a phase angle of the first sampled signal.

The tested signal acquisition unit and the reference signal acquisition unit are connected to the same analog-to-digital conversion unit. After the first sampled signals and the second sampled signals are sent to the analog-to-digital conversion unit, the analog-to-digital conversion unit converts the first sampled signals and the second sampled signals into digital signals, and sends the digital signals obtained through conversion to a signal processing module. The signal processing module may calculate amplitudes of the first sampled signals, and calculate a phase angle difference between the first sampled signal and the second sampled signal that correspond to the same frequency point. A phase angle of the second sampled signal may be determined based on the parameters of the reference signal acquisition unit and the injected signal, so that the phase angle of the first sampled signal may be determined based on the phase angle difference between the first sampled signal and the second sampled signal and the phase angle of the second sampled signal.

It should be noted that the amplitudes of the first sampled signal, phase angle differences between the first sampled signals and the second sampled signals, and phase angles of the second sampled signals may be calculated in any appropriate manner. This is not limited in this embodiment of this application.

In this embodiment of this application, the test signal generated by the signal generation apparatus is injected into both the tested signal acquisition unit and the reference signal acquisition unit, the test signal is sampled at the plurality of frequency points via the tested signal acquisition unit and the reference signal acquisition unit, to obtain the first sampled signals and the second sampled signals corresponding to the frequency points, and the amplitudes of the first sampled signals and the phase angle differences between the first sampled signals and the second sampled signals may be further calculated. The phase angles of the second sampled signals may be directly determined, so that the phase angles of the first sampled signals may be calculated based on the phase angle differences between the first sampled signals and the second sampled signals and the phase angles of the second sampled signals. In this way, the amplitudes and the phase angles of the first sampled signals are obtained. The amplitudes and the phase angles of the first sampled signals acquired by the tested signal acquisition unit are determined with reference to the second sampled signals acquired by the reference signal acquisition unit, so that accuracy of the obtained amplitudes and phase angles is ensured.

In a possible implementation, a target function may be constructed according to a least squares method and based on the amplitudes and the phase angles of the sampled signals obtained by the tested signal acquisition unit through sampling, and the amplitude gain factor and the time constant of the tested signal acquisition unit may be obtained by solving the target function. In the constructed target function, the amplitude gain factor and the time constant of the tested signal acquisition unit are variables, and the amplitudes and the phase angles of the sampled signals acquired by the tested signal acquisition unit are constants.

It is defined that an analog signal transmission system includes an induction unit and the tested signal acquisition unit in the to-be-calibrated electronic transformer, the actual cut-off frequency of the tested signal acquisition unit is $f_c$, and the amplitude gain factor is $M$. In this case, a transfer function corresponding to the analog signal transmission system is

$$G_0(s) = \frac{M}{1+s\cdot\frac{1}{2\pi f_c}}$$, where s is used to represent an s domain (complex frequency domain), and $\pi$ is used to represent the circumference ratio. Without considering a measurement error and other conditions, the amplitudes and the phase angles of the sampled signals acquired by the tested signal acquisition unit should satisfy a relationship in the transfer function $G_0(s)$. In a practical measurement system, it is difficult to ensure that amplitudes and phase angles at all frequency points satisfy the relationship in the transfer function. To maximally reduce errors at all the frequency points, optimal solutions for the cut-off frequency $f_c$ and the amplitude gain factor M in the transfer function $G_0(s)$ need to be found.

Therefore, the target function may be constructed according to the least squares method and based on the transfer function $G_0(s)$, and the amplitude gain factor and the time constant of the tested signal acquisition unit may be determined by solving the target function.

In an example, the constructed target function is as follows:

$$y(T, M) = \sum_{k=1}^{N} \left| \frac{M}{1 + j2\pi f_k T} - A_k e^{j\theta_k} \right|^2$$

N is used to represent a quantity of the frequency points, and j is used to represent an imaginary number. $f_k$ is used to represent a frequency value corresponding to a $k^{th}$ frequency point. $A_k$ is used to represent an amplitude of a sampled signal obtained by the tested signal acquisition unit by sampling the test signal at the $k^{th}$ frequency point. $\theta_k$ is used to represent a phase angle of the sampled signal obtained by the tested signal acquisition unit by sampling the test signal at the $k^{th}$ frequency point. $e$ is used to represent a natural constant. M is used to represent the amplitude gain factor. T is used to represent the time constant.

The target function is constructed according to the least squares method and based on the amplitudes and the phase angles of the sampled signals acquired by the tested signal acquisition unit, and solutions for the amplitude gain factor M and the time constant T that minimize $y(T, M)$ are found, maximally reducing amplitude and phase angle errors at all the frequency points. This ensures that the obtained amplitude gain factor M and time constant T match the tested signal acquisition unit, thereby ensuring high measurement precision of the electronic transformer after the electronic transformer is calibrated.

In this embodiment of this application, a manner for solving the target function is not limited, and various appropriate manners can be used to solve the target function. The following uses an example to describe a process of solving the target function. In this example, the manner for solving the target function is not limited.

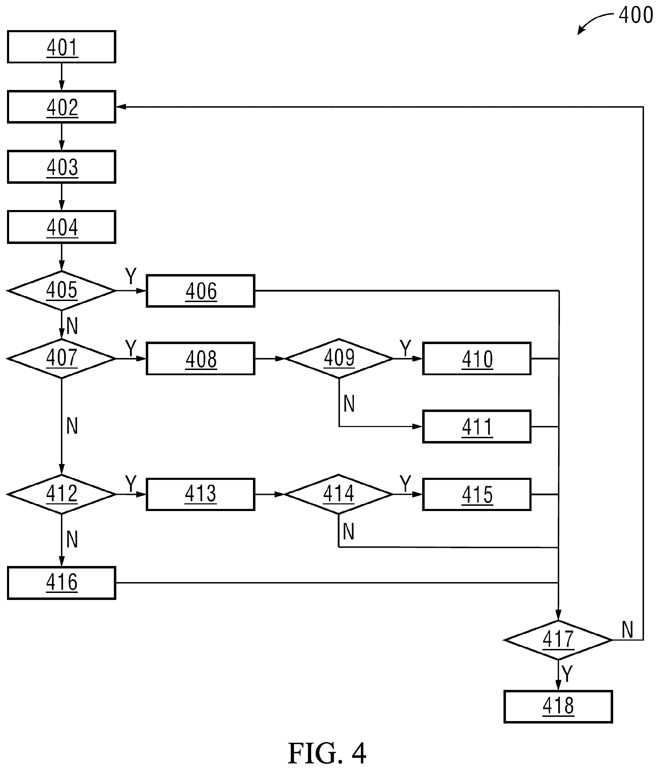

FIG. 4 is a flowchart of a target function solving method 400 according to an embodiment of this application. As shown in FIG. 4, the target function solving method 400 includes the following steps.

Step 401: Initialize a vertex $x_1$, a vertex $x_2$, and a vertex $x_3$.

The vertex $x_1$ is $(T_0, M_0)$. The vertex $x_2$ is $(T_0 \cdot (1 + \Delta), M_0)$. The vertex $x_3$ is $(T_0, M_0 \cdot (1 + \Delta))$. $T_0$ is an initial time constant. $M_0$ is an initial amplitude gain factor. $\Delta$ is a set value. For example, $\Delta$ may be equal to 5%. $T_0$ and $M_0$ may be both obtained based on theoretical values of a circuit design of the electronic transformer, for example, may be both obtained through calculation based on an acquisition circuit of an RC filter included.

Step 402: Re-sort the three vertexes in ascending order of corresponding function values.

Since values corresponding to the vertex $x_1$, the vertex $x_2$, and the vertex $x_3$ are updated in a subsequent step, each time the value of any one of the three vertexes is updated, the three vertexes are respectively substituted into the target function to obtain corresponding function values, and then the three vertexes are re-sorted in ascending order of the corresponding function values, where a vertex corresponding to a minimum function value is the vertex $x_1$, a vertex corresponding to a maximum function value is the vertex $x_3$, and a vertex corresponding to an intermediate function value is the vertex $x_2$. In other words, $y(x_1) \le y(x_2) \le y(x_3)$, where $y(x_1)$ is a function value of the vertex $x_1$ after re-sorting, $y(x_2)$ is a function value of the vertex $x_2$ after re-sorting, and $y(x_3)$ is a function value of the vertex $x_3$ after re-sorting.

Step 403: Calculate a centroid $x_o$ based on the three vertexes.

The centroid $x_o$ is equal to an average value of the vertex $x_1$, the vertex $x_2$, and the vertex $x_3$.

Step 404: Calculate a reflection point $x_r$ based on the three vertexes.

The reflection point $x_r$ may be obtained through calculation using a formula $x_r = x_o + \alpha(x_o - x_3)$. $\alpha$ represents a reflection factor. For example, $\alpha$ is equal to 1.

Step 405: Determine whether $y(x_1) \le y(x_r) < y(x_2)$ is true. If a determining result is that $y(x_1) \le y(x_r) < y(x_2)$ is true, step 406 is performed; or if a determining result is that $y(x_1) \le y(x_r) < y(x_2)$ is not true, step 407 is performed.

$y(x_1)$ is the function value of the vertex $x_1$. $y(x_r)$ is a function value of the reflection point $x_r$. $y(x_2)$ is the function

value of the vertex $x_2$.

Step 406: Replace the vertex $x_3$ with the reflection point $x_r$, and perform step 417.

If it is determined that $y(x_1) \leq y(x_r) < y(x_2)$ is true, the vertex $x_3$ is updated to make the value of the vertex $x_3$ equal to a value of the reflection point $x_r$, and then step 417 is performed.

Step 407: Determine whether $y(x_r) < y(x_1)$ is true. If a determining result is that y(x_r) < y(x_1) is true, step 408 is performed; or if a determining result is that y(x_r) < y(x_1) is not true, step 412 is performed.

Step 408: Calculate an expansion point $x_e$ based on the centroid $x_o$ and the reflection point $x_r$.

The expansion point $x_e$ may be obtained through calculation using a formula $x_e = x_o + \gamma(x_r - x_o)$. $\gamma$ is a set constant. For example, $\gamma$ is equal to 2.

Step 409: Determine whether $y(x_e) < y(x_r)$ is true. If a determining result is that $y(x_e) < y(x_r)$ is true, step 410 is performed; or if a determining result is that $y(x_e) < y(x_r)$ is not true, step 411 is performed.

$y(x_e)$ is a function value of the expansion point $x_e$. The function value of the expansion point $x_e$ may be obtained by substituting the expansion point $x_e$ into the target function.

Step 410: Replace the vertex $x_3$ with the expansion point $x_e$, and perform step 417.

Step 411: Replace the vertex $x_3$ with the reflection point $x_r$, and perform step 417.

Step 412: Determine whether $y(x_r) \geq y(x_2)$ is true. If a determining result is that $y(x_r) \geq y(x_2)$ is true, step 413 is performed; or if a determining result is that $y(x_r) \geq y(x_2)$ is not true, step 416 is performed.

Step 413: Calculate a contraction point $x_c$ based on the centroid $x_o$ and the vertex $x_3$.

The contraction point $x_c$ may be obtained through calculation using a formula $x_c = x_o + \rho(x_3 - x_o)$. $\rho$ is a contraction factor, which is a set constant. For example, $\rho$ is equal to 0.5.

Step 414: Determine whether $y(x_c) < y(x_3)$ is true. If a determining result is that y(x_c) < y(x_3) is true, step 415 is performed; or if a determining result is that y(x_c) < y(x_3) is not true, step 417 is performed.

Step 415: Replace the vertex $x_3$ with the contraction point $x_c$, and perform step 417.

Step 416: Recalculate the vertex $x_2$ and the vertex $x_3$.

The vertex $x_2$ is updated using a formula $x_2 = x_1 + \sigma(x_2 - x_1)$, and the vertex $x_3$ is updated using a formula $x_3 = x_1 + \sigma(x_3 - x_1)$. $\sigma$ is a contraction factor, for example, is 0.5. Step 417: Determine whether an iteration termination condition is satisfied. If a determining result is that the iteration termination condition is satisfied, step 418 is performed; or if a determining result is that the iteration termination condition is not satisfied, step 402 is performed.

The iteration termination condition may be that the function value of the target function is less than a target threshold, or that an iteration count reaches a set value.

Step 418: Determine a horizontal coordinate and a vertical coordinate of the vertex $x_1$ sequentially as the amplitude gain factor and the time constant.

In other words, the horizontal coordinate of the vertex $x_1$ is the amplitude gain factor, and the vertical coordinate of the vertex $x_1$ is the time constant.

In this embodiment of this application, the target function is constructed according to the least squares method and based on the amplitudes and the phase angles of the sampled signals acquired by the tested signal acquisition unit. A variable of the target function includes the amplitude gain factor and the time constant of the tested signal acquisition unit. The amplitude gain factor and the time constant of the tested signal acquisition unit are obtained by solving the target function, so that the obtained amplitude gain factor and time constant are adapted to the sampled signals of different frequencies, ensuring high precision of measurement results obtained when the calibrated electronic transformer measures currents or voltages of different frequencies.

In a possible implementation, a deviation of a capacitor included in the filter in the tested signal acquisition unit affects the cut-off frequency of the tested signal acquisition unit more significantly, so that capacitance may be corrected to make a constructed signal transmission model close to the analog signal transmission system.

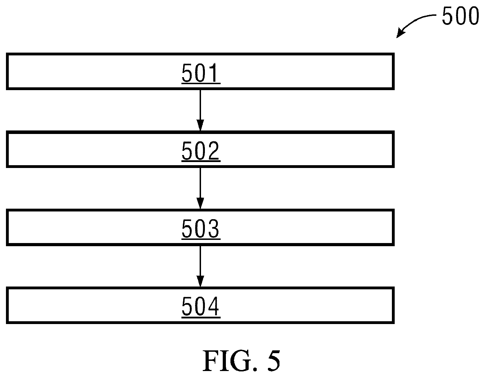

FIG. 5 is a flowchart of a dominant pole and amplitude factor determining method 500 according to an embodiment of this application. As shown in FIG. 5, the dominant pole and amplitude factor determining method 500 includes the following steps.

Step 501: Determine a cut-off frequency of the filter in the tested signal acquisition unit based on the time constant.

The time constant and the cut-off frequency of the tested signal acquisition unit satisfies $T = \dfrac{1}{2\pi f_{c_{real}}}$. $T$ is used to represent the time constant of the tested signal acquisition unit. $f_{c_{real}}$ is used to represent the actual cut-off frequency of the tested signal acquisition unit. $\pi$ is used to represent the circumference ratio. After the time constant of the tested signal acquisition unit is obtained, the cut-off frequency of the tested signal acquisition unit may be calculated based on the foregoing relationship.

Step 502: Determine actual capacitance of the capacitor in the filter based on the cut-off frequency of the filter.

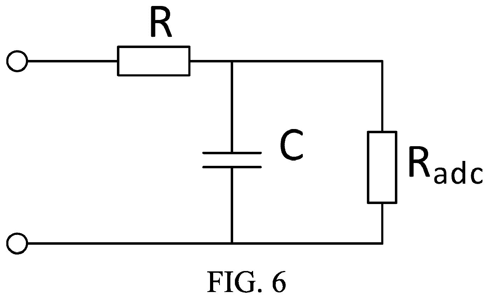

To achieve high precision of the electronic transformer, the tested signal acquisition unit uses a high-precision resistive or capacitive component. Analysis on impact of deviations of resistance and capacitance shows that the deviation of the capacitive component affects the cut-off frequency more significantly. Therefore, the capacitance may be corrected to make the constructed signal transmission system closer to the analog signal transmission system. For example, the tested signal acquisition unit includes a first-order RC filter shown in FIG. 6. A theoretical cut-off frequency corresponding to this part of circuit is $fc_{ideal} = \frac{R+R_{adc}}{2\pi \cdot R \cdot R_{adc} \cdot C}$, where both $R$ and $R_{adc}$ represent resistance, and C represents capacitance. The actual cut-off frequency $f_{Creal}$ determined based on the time constant is substituted into the foregoing formula, to obtain actual capacitance of the capacitance in the RC filter of this part: $C_{new} = \frac{2\pi \cdot R \cdot R_{adc} \cdot f_{Creal}}{R+R_{adc}}$.

It should be noted that in the foregoing embodiment, the example in which the filter in the tested signal acquisition unit is the first-order RC filter is used to describe a method for calculating the actual capacitance of the capacitor in the filter. When the filter in the tested signal acquisition unit is another circuit structure, a capacitor corresponding to the dominant pole of the filter may be found, and actual capacitance of the capacitor corresponding to the dominant pole may be calculated using a similar method.

Step 503: Update the signal transmission model with the actual capacitance, and perform pole-zero analysis on the signal transmission model to obtain the dominant pole of the tested signal acquisition unit.

The analog signal transmission system includes the induction unit and the tested signal acquisition unit in the to-be-calibrated electronic transformer. The signal transmission model may be obtained by modeling the analog signal transmission system. After the actual capacitance of the capacitor included in the filter in the tested signal acquisition unit is obtained, the signal transmission model may be updated with the actual capacitance, and then a dominant pole matching the analog signal transmission system may be obtained by performing pole-zero analysis on the signal transmission model. The dominant pole is the dominant pole of the tested signal acquisition unit.

A pole-zero circuit is a circuit design concept, and is configured to describe poles (poles) and zeros (zeros) in the circuit.

Step 504: Transform the amplitude gain factor to obtain the amplitude factor of the tested signal acquisition unit.

The amplitude factor and the amplitude gain factor of the tested signal acquisition unit have the specific mathematical relationship, so that the amplitude factor of the tested signal acquisition unit may be determined by performing mathematical transformation on the amplitude gain factor.

In an example, the amplitude factor of the tested signal acquisition unit is the amplitude gain factor, or the amplitude factor may be obtained by performing linear transformation on the amplitude gain factor.

Step 504 may be performed at the same time as steps 501 to 503, or may be performed before or after steps 501 to 503. This is not specially limited.

In this embodiment of this application, the cut-off frequency of the filter in the tested signal acquisition unit is the cut-off frequency of the tested signal acquisition unit, and a frequency corresponding to the dominant pole of the tested signal acquisition unit is the cut-off frequency of the tested signal acquisition unit. Based on this relationship, the capacitance of the capacitor in the filter corresponding to the dominant pole may be corrected to obtain the actual capacitance. Further, after the signal transmission model is updated with the actual capacitance, the dominant pole of the tested signal acquisition unit may be obtained by performing pole-zero analysis on the signal transmission model. In this way, accuracy of the obtained dominant pole is ensured, further ensuring the precision of the measurement result obtained by the calibrated electronic transformer.

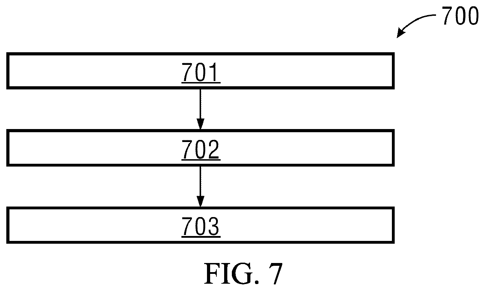

In a possible implementation, FIG. 7 is a flowchart of a digital signal processing unit configuration method 700 according to an embodiment of this application. As shown in FIG. 7, the digital signal processing unit configuration method 700 includes the following steps.

Step 701: Construct an analog filter based on the dominant pole and the amplitude factor.

A digital filter is generally designed through conversion from the analog filter. The analog filter is constructed using a pole-zero cancellation method based on the dominant pole and the amplitude factor of the tested signal acquisition unit.

In an example, the analog filter may be expressed as the following formula (1):

$$H_{corr}(s) = \frac{1}{K} \cdot \frac{(s - p_{1_{new}})}{(s - p_k)} \tag{1}$$

$H_{corr}(s)$ is used to represent the analog filter. $s$ is used to represent the s domain (the complex frequency domain). $p_{1\_new}$ is for the dominant pole of the tested signal acquisition unit. $p_k$ is used to represent a $k^{th}$ pole. $K$ is used to represent the amplitude factor of the tested signal acquisition unit.

Step 702: Perform bilinear transformation on the analog filter to obtain an intermediate digital filter.

After the analog filter is constructed, the analog filter may be converted into the intermediate digital filter through bilinear transformation.

In an example, when the analog filter is expressed as the foregoing formula (1), the intermediate digital filter may be expressed as the following formula (2):

$$H_{corr}(z^{-1}) = \frac{1}{K} \cdot \frac{b_1 z^{-1} + b_0}{a_1 z^{-1} + 1} \qquad (2)$$

$H_{corr}(z^{-1})$ is used to represent the intermediate digital filter. $z$ is used to represent a zero of the tested signal acquisition unit. $b_1 = \frac{1-2f_s \cdot T_{1\_new}}{1+2f_s \cdot T_k} \cdot \frac{T_k}{T_{1\_new}}$   $b_0 = \frac{1+2f_s \cdot T_{1\_new}}{1+2f_s \cdot T_k} \cdot \frac{T_k}{T_{1\_new}}$ .   $a_1 = \frac{1-2f_s \cdot T_k}{1+2f_s \cdot T_k}$ .   $T_{1\_new} = \frac{1}{|p_{1\_new}|}$ . $T_k$ is a target time constant, for example, is any constant from 0.1 seconds to 0.5 seconds. $f_s$ is a sampling frequency of the tested signal acquisition unit.

Step 703: Convert the intermediate digital filter into a difference equation to obtain the digital filter.

For ease of a real-time operation of the digital signal processing unit, the intermediate digital filter is converted into the difference equation to obtain the digital filter. The digital signal processing unit may perform digital filtering on the input signal via the digital filter, to obtain the output signal.

In an example, when the intermediate digital filter is expressed as the foregoing formula (2), the digital filter may be expressed as the following formula (3):

$$y[n] = \frac{1}{K} \cdot (b_0 \cdot x[n] + b_1 \cdot x[n-1]) - a_1 \cdot y[n-1] \qquad (3)$$

$y[n]$ is used to represent an output signal of the digital filter at a current sampling point. $y[n-1]$ is used to represent an output signal of the digital filter at a previous sampling point. $x[n]$ is an input signal of the digital filter at the current sampling point. $x[n-1]$ is an input signal of the digital filter at the previous sampling point.

In this embodiment of this application, after the analog filter is constructed based on the dominant pole and the amplitude factor of the tested signal acquisition unit, the analog filter is converted into the intermediate digital filter through bilinear transformation, and then the intermediate digital filter is converted into the difference equation, so that the digital signal processing unit may perform the real-time operation via the digital filter, ensuring real-time performance of measurement of a current or a voltage by the electronic transformer while ensuring the measurement precision of the electronic transformer.

Electronic transformer calibration apparatus

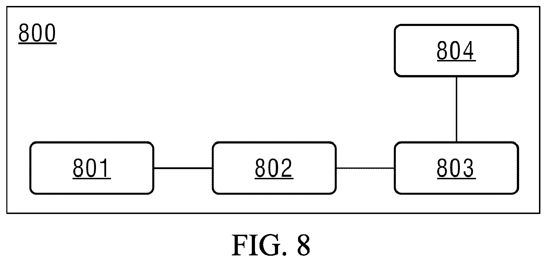

FIG. 8 is a schematic diagram of an electronic transformer calibration apparatus 800 according to an embodiment of this application. As shown in FIG. 8, the electronic transformer calibration apparatus 800 includes:

an obtaining module 801, configured to obtain amplitudes and phase angles of sampled signals obtained by a tested signal acquisition unit by sampling different frequency signals, where the tested signal acquisition unit is a signal acquisition unit included in a to-be-calibrated electronic transformer;

a first calculation module 802, configured to determine an amplitude gain factor and a time constant of the tested signal acquisition unit based on the amplitudes and the phase angles;

a second calculation module 803, configured to determine a dominant pole and an amplitude factor of the tested signal acquisition unit based on the amplitude gain factor and the time constant; and

a configuration module 804, configured to configure the dominant pole and the amplitude factor for a digital signal processing unit included in the to-be-calibrated electronic transformer, so that the digital signal processing unit performs digital filtering on an input signal based on the dominant pole and the amplitude factor, to obtain an output signal, where the input signal is obtained by performing analog-to-digital conversion on a signal output by the tested signal acquisition unit.

In this embodiment of this application, after the obtaining module 801 obtains the amplitudes and the phase angles of the sampled signals of different frequencies acquired by the tested signal acquisition unit, the first calculation module 802 determines the amplitude gain factor and the time constant based on the amplitudes and the phase angles, the second calculation module 803 determines the dominant pole and the amplitude factor based on the amplitude gain factor and the time constant, and the configuration module 804 configures the dominant pole and the amplitude factor for the digital signal processing unit, so that the digital signal processing unit performs digital filtering on the input signal based on the dominant pole and the amplitude factor, to obtain the output signal that can indicate a measured primary current or voltage. Since the time constant has a linear relationship with an actual cut-off frequency of the tested signal acquisition unit, after the dominant pole and the amplitude factor determined based on the amplitude gain factor and the time constant are configured for the digital signal processing unit, the digital signal processing unit can calculate the measured primary current or voltage based on the actual cut-off frequency of the tested signal acquisition unit, ensuring measurement precision of the electronic transformer. The time constant and the amplitude gain factor are determined based on the amplitudes and the phase angles of the sampled signals of different frequencies, so that the dominant pole and the amplitude factor are adapted to a wide operating frequency range, ensuring the measurement precision of the electronic transformer in measuring different frequencies and primary currents or voltages.

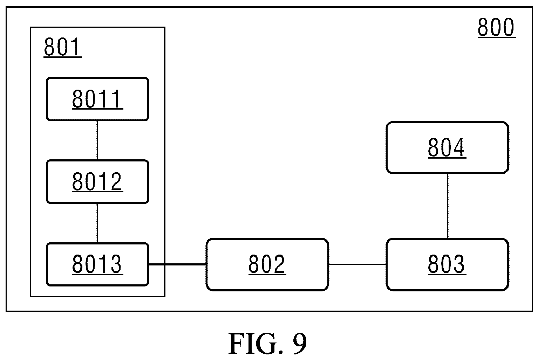

In a possible implementation, FIG. 9 shows the electronic transformer calibration apparatus 800 according to another embodiment of this application. The obtaining module 801 includes:

an input submodule 8011, configured to input a test signal generated by a signal generation apparatus separately into the tested signal acquisition unit and a reference signal acquisition unit;
a sampling submodule 8012, configured to sample the test signal at a plurality of different frequency points of the test signal via the tested signal acquisition unit and the reference signal acquisition unit, to obtain a plurality of first sampled signals acquired by the tested signal acquisition unit and a plurality of second sampled signals acquired by the reference signal acquisition unit; and
an operation submodule 8013, configured to determine, based on the first sampled signal and the second sampled signal that correspond to a same frequency point, an amplitude and a phase angle of the first sampled signal.

In a possible implementation, frequency values corresponding to the plurality of frequency points are located within a range of 1 Hz to 80 Hz.

In a possible implementation, the first calculation module 802 is configured to construct a target function according to a least squares method, and solve the target function to obtain the amplitude gain factor and the time constant of the tested signal acquisition unit, where a variable of the target function includes the amplitude gain factor and the time constant of the tested signal acquisition unit, and a constant of the target function includes the amplitudes and the phase angles of the sampled signals obtained by the tested signal acquisition unit by sampling the test signal at the plurality of frequency points.

In a possible implementation, the target function includes:

$$y(T, M) = \sum_{k=1}^{N} \left| \frac{M}{1 + j2\pi f_k T} - A_k e^{j\theta_k} \right|^2$$

N is used to represent a quantity of the frequency points, and j is used to represent an imaginary number. $f_k$ is used to represent a frequency value corresponding to a $k^{th}$ frequency point. $A_k$ is used to represent an amplitude of a sampled signal obtained by the tested signal acquisition unit by sampling the test signal at the $k^{th}$ frequency point. $\theta_k$ is used to represent a phase angle of the sampled signal obtained by the tested signal acquisition unit by sampling the test signal at the $k^{th}$ frequency point. $e$ is used to represent a natural constant. M is used to represent the amplitude gain factor. T is used to represent the time constant.

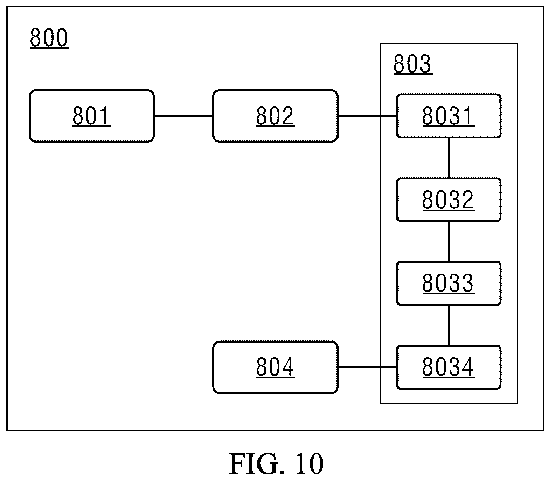

In a possible implementation, FIG. 10 shows the electronic transformer calibration apparatus 800 according to still another embodiment of this application. The second calculation module 803 includes:

a first construction submodule 8031, configured to determine a cut-off frequency of a filter in the tested signal acquisition unit based on the time constant;
a second calculation submodule 8032, configured to determine actual capacitance of a capacitor in the filter based on the cut-off frequency of the filter;
an analysis submodule 8033, configured to update a signal transmission model with the actual capacitance, and perform pole-zero analysis on the signal transmission model to obtain the dominant pole of the tested signal acquisition unit, where the signal transmission model is obtained by modeling an analog signal transmission system, the analog signal transmission system including an induction unit and the tested signal acquisition unit in the to-be-calibrated electronic transformer; and
a first transformation submodule 8034, configured to transform the amplitude gain factor to obtain the amplitude factor of the tested signal acquisition unit.

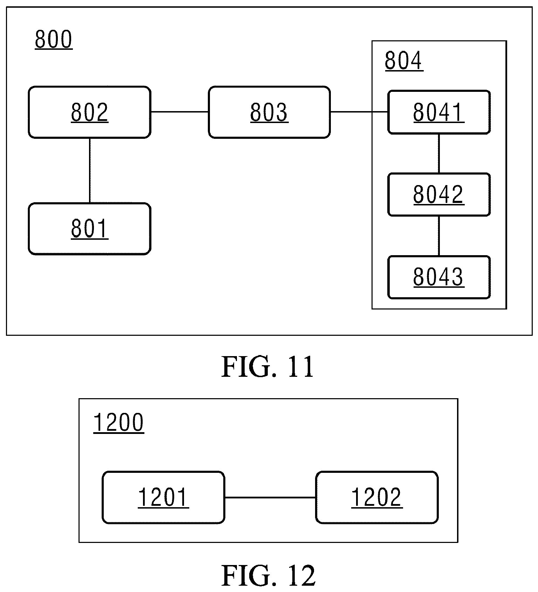

In a possible implementation, FIG. 11 shows the electronic transformer calibration apparatus 800 according to still yet another embodiment of this application. The configuration module 804 includes:

a second construction submodule 8041, configured to construct an analog filter based on the dominant pole and the amplitude factor;
a second transformation submodule 8042, configured to perform bilinear transformation on the analog filter to obtain an intermediate digital filter; and
a conversion submodule 8043, configured to convert the intermediate digital filter into a difference equation to obtain a digital filter, where the digital filter is configured to perform digital filtering on the input signal to obtain the output signal.

In a possible implementation, the analog filter includes:

$$H_{corr}(s) = \frac{1}{K} \cdot \frac{(s - p_{1\_new})}{(s - p_k)}$$

the intermediate digital filter includes:

$$H_{corr}(z^{-1}) = \frac{1}{K} \cdot \frac{b_1 z^{-1} + b_0}{a_1 z^{-1} + 1}$$

the digital filter includes:

$$y[n] = \frac{1}{K} \cdot (b_0 \cdot x[n] + b_1 \cdot x[n-1]) - a_1 \cdot y[n-1]$$

$H_{corr}(s)$ is used to represent the analog filter. $s$ is used to represent a complex frequency domain. $p_{1\_new}$ is used to represent the dominant pole. $p_k$ is used to represent a $k^{th}$ pole. $K$ is used to represent the amplitude factor. $H_{corr}(z^{-1})$ is used to represent the intermediate digital filter. $z$ is used to represent a zero. $b_1 = \frac{1 - 2f_s \cdot T_{1\_new}}{1 + 2f_s \cdot T_k} \cdot \frac{T_k}{T_{1\_new}}$ .

$b_0 = \frac{1 + 2f_s \cdot T_{1\_new}}{1 + 2f_s \cdot T_k} \cdot \frac{T_k}{T_{1\_new}}$ . $a_1 = \frac{1 - 2f_s \cdot T_k}{1 + 2f_s \cdot T_k}$ . $T_{1\_new} = \frac{1}{|p_{1\_new}|}$ . $T_k$ is a constant. $f_s$ is a sampling frequency of the tested signal acquisition unit. $y[n]$ is used to represent an output signal of the digital filter at a current sampling point. $y[n - 1]$ is used to represent an output signal of the digital filter at a previous sampling point. $x[n]$ is an input signal of the digital filter at the current sampling point. $x[n - 1]$ is an input signal of the digital filter at the previous sampling point.

It should be noted that content such as information exchange between the modules and submodules of the electronic transformer calibration apparatus 800 and execution processes is based on a same idea as that of the method embodiment. For specific content, refer to the descriptions in the method embodiment. Details are not described herein again.

Electronic transformer calibration apparatus

FIG. 12 is a schematic diagram of an electronic transformer calibration apparatus 1200 according to an embodiment of this application. As shown in FIG. 12, the electronic transformer calibration apparatus 1200 includes at least one memory 1201 and at least one processor 1202. The memory 1201 is configured to store instructions. The processor 1202 is configured to perform, according to the instructions stored in the memory 1201, the electronic transformer calibration method described in any one of the foregoing embodiments.

Computer-readable storage medium

The present disclosure further provides a computer-readable storage medium storing instructions for causing a machine to perform the electronic transformer calibration method herein. Specifically, a system or an apparatus configured with a storage medium may be provided, where software program code for implementing a function in any one of the foregoing embodiments is stored on the storage medium, and a computer (or a CPU or an MPU) of the system or the apparatus is caused to read and execute the program code stored on the storage medium.

In this case, the program code read from the storage medium can cause the function in any one of the foregoing embodiments to be implemented, and therefore the program code and the storage medium storing the program code constitute a part of the present disclosure.

Embodiments of the storage medium for providing the program code include a floppy disk, a hard disk drive, a magneto-optical disk, an optical disk (for example, a compact disc CD-ROM, a CD-R, a CD-RW, a DVD-ROM, a DVD-RAM, a DVD-RW, or a DVD+RW), a magnetic tape, a non-volatile storage card, and a ROM. Optionally, the program code may be downloaded from a server computer using a communication network.

It should be noted that in this specification, relational terms such as first and second are only used to distinguish one entity or operation from another, and do not necessarily require or imply that any actual relationship or sequence exists between these entities or operations. Moreover, the terms "include" and "comprise", or any of their variants are intended to cover a non-exclusive inclusion, so that a process, method, article, or device that includes a list of elements not only includes those elements but also includes other elements that are not expressly listed, or further includes elements inherent to such process, method, article, or device. If no more limitations are made, an element limited by "including a/an..." does not exclude other same elements existing in the process, method, article, or device that includes the element.

Not all steps and units in the procedures and the diagrams of the system structures are necessary, and some steps or units may be omitted according to an actual requirement. An execution sequence of the steps is not fixed and may be adjusted according to a requirement. The system structure described in the embodiments may be a physical structure or a logical structure. That is, some units may be implemented by the same physical entity, or some units may be implemented by a plurality of physical entities, or may be implemented by some components in a plurality of independent devices together.

In the embodiments, the hardware modules may be implemented mechanically or electrically. For example, a hardware module may include a permanent dedicated circuit or logic (for example, a dedicated processor, FPGA, or ASIC) to complete a corresponding operation. The hardware module may further include programmable logic or a circuit (for example, a general-purpose processor or another programmable processor), which may be temporarily set by software to complete a corresponding operation. A specific implementation (the mechanical manner, the dedicated permanent circuit, or the temporarily set circuit) may be determined based on costs and time considerations.

Although the foregoing illustrates and describes this application in detail using the accompanying drawings and preferred embodiments, this application is not limited to these disclosed embodiments. Based on the foregoing plurality of embodiments, it may be appreciated by a person skilled in the art that code review means in different embodiments may be combined to obtain more embodiments of this application, and these embodiments also fall within the protection scope of this application.

**Claims**

1. An electronic transformer calibration method (100), comprising:

    obtaining amplitudes and phase angles of sampled signals obtained by a tested signal acquisition unit (12) by sampling different frequency signals, wherein the tested signal acquisition unit (12) is a signal acquisition unit comprised in a to-be-calibrated electronic transformer;
    determining an amplitude gain factor and a time constant of the tested signal acquisition unit (12) based on the amplitudes and the phase angles;
    determining a dominant pole and an amplitude factor of the tested signal acquisition unit (12) based on the amplitude gain factor and the time constant; and
    configuring the dominant pole and the amplitude factor for a digital signal processing unit (14) comprised in the to-be-calibrated electronic transformer, so that the digital signal processing unit (14) performs digital filtering on an input signal based on the dominant pole and the amplitude factor, to obtain an output signal, wherein the input signal is obtained by performing analog-to-digital conversion on a signal output by the tested signal acquisition unit (12).

2. The method according to claim 1, wherein the obtaining amplitudes and phase angles of sampled signals obtained by a tested signal acquisition unit (12) by sampling different frequency signals comprises:

    inputting a test signal generated by a signal generation apparatus separately into the tested signal acquisition unit (12) and a reference signal acquisition unit;
    obtaining a plurality of first sampled signals acquired by the tested signal acquisition unit (12) and a plurality of second sampled signals acquired by the reference signal acquisition unit, wherein the first sampled signals and the second sampled signals are obtained by sampling the test signal at a plurality of different frequency points of the test signal via the tested signal acquisition unit (12) and the reference signal acquisition unit; and determining, based on a first sampled signal and a second sampled signal that correspond to a same frequency point, an amplitude and a phase angle of the first sampled signal.

3. The method according to claim 2, wherein frequency values corresponding to the plurality of frequency points are located within a range of 1 Hz to 80 Hz.

4. The method according to claim 1, wherein the determining an amplitude gain factor and a time constant of the tested signal acquisition unit (12) based on the amplitudes and the phase angles comprises:

   constructing a target function according to a least squares method, wherein a variable of the target function comprises the amplitude gain factor and the time constant of the tested signal acquisition unit (12), and a constant of the target function comprises the amplitudes and the phase angles of the sampled signals obtained by the tested signal acquisition unit (12) through sampling; and
   solving the target function to obtain the amplitude gain factor and the time constant of the tested signal acquisition unit (12).

5. The method according to claim 4, wherein the target function comprises:

$$y(T, M) = \sum_{k=1}^{N} \left| \frac{M}{1 + j2\pi f_k T} - A_k e^{j\theta_k} \right|^2,$$

wherein
N is used to represent a quantity of the frequency points, j is used to represent an imaginary number, $f_k$ is used to represent a frequency value corresponding to a $k^{th}$ frequency point, $A_k$ is used to represent an amplitude of a sampled signal obtained by the tested signal acquisition unit (12) by sampling the test signal at the $k^{th}$ frequency point, $\theta_k$ is used to represent a phase angle of the sampled signal obtained by the tested signal acquisition unit (12) by sampling the test signal at the $k^{th}$ frequency point, e is used to represent a natural constant, M is used to represent the amplitude gain factor, and T is used to represent the time constant.

6. The method according to claim 1, wherein the determining a dominant pole and an amplitude factor of the tested signal acquisition unit (12) based on the amplitude gain factor and the time constant comprises:

   determining a cut-off frequency of a filter in the tested signal acquisition unit (12) based on the time constant;
   determining actual capacitance of a capacitor in the filter based on the cut-off frequency of the filter;
   updating a signal transmission model with the actual capacitance, and performing pole-zero analysis on the signal transmission model to obtain the dominant pole of the tested signal acquisition unit (12), wherein the signal transmission model is obtained by modeling an analog signal transmission system, the analog signal transmission system comprising an induction unit (11) and the tested signal acquisition unit (12) in the to-be-calibrated electronic transformer; and
   transforming the amplitude gain factor to obtain the amplitude factor of the tested signal acquisition unit (12).

7. The method according to any one of claims 1 to 6, wherein the configuring the dominant pole and the amplitude factor for a digital signal processing unit (14) comprised in the to-be-calibrated electronic transformer comprises:

   constructing an analog filter based on the dominant pole and the amplitude factor;
   performing bilinear transformation on the analog filter to obtain an intermediate digital filter; and
   converting the intermediate digital filter into a difference equation to obtain a digital filter, wherein the digital filter is configured to perform digital filtering on the input signal to obtain the output signal.

8. The method according to claim 7, wherein
the analog filter comprises:

$$H_{corr}(s) = \frac{1}{K} \cdot \frac{(s - p_{1\_new})}{(s - p_k)};$$

the intermediate digital filter comprises:

$$H_{corr}(z^{-1}) = \frac{1}{K} \cdot \frac{b_1 z^{-1} + b_0}{a_1 z^{-1} + 1};$$

and
the digital filter comprises:

$$y[n] = \frac{1}{K} \cdot (b_0 \cdot x[n] + b_1 \cdot x[n-1]) - a_1 \cdot y[n-1]$$ , wherein

$H_{corr}(s)$ is used to represent the analog filter, s is used to represent a complex frequency domain, $p_{1\_new}$ is used to represent the dominant pole, $p_k$ is used to represent a $k^{th}$ pole, and $K$ is used to represent the amplitude factor; and $H_{corr}(z^{-1})$ is used to represent the intermediate digital filter, z is used to represent a zero,

$$b_1 = \frac{1 - 2f_s \cdot T_{1\_new}}{1 + 2f_s \cdot T_k} \cdot \frac{T_k}{T_{1\_new}}, \quad b_0 = \frac{1 + 2f_s \cdot T_{1\_new}}{1 + 2f_s \cdot T_k} \cdot \frac{T_k}{T_{1\_new}}, \quad a_1 = \frac{1 - 2f_s \cdot T_k}{1 + 2f_s \cdot T_k}, \quad T_{1\_new} = \frac{1}{|p_{1\_new}|}, T_k$$

is a constant, $f_s$ is a sampling frequency of the tested signal acquisition unit (12), y[n] is used to represent an output signal of the digital filter at a current sampling point, y[n - 1] is used to represent an output signal of the digital filter at a previous sampling point, x[n] is an input signal of the digital filter at the current sampling point, and x[n - 1] is an input signal of the digital filter at the previous sampling point.

9. An electronic transformer calibration apparatus (800), comprising:

an obtaining module (801), configured to obtain amplitudes and phase angles of sampled signals obtained by a tested signal acquisition unit (12) by sampling different frequency signals, wherein the tested signal acquisition unit (12) is a signal acquisition unit comprised in a to-be-calibrated electronic transformer;
a first calculation module (802), configured to determine an amplitude gain factor and a time constant of the tested signal acquisition unit (12) based on the amplitudes and the phase angles;
a second calculation module (803), configured to determine a dominant pole and an amplitude factor of the tested signal acquisition unit (12) based on the amplitude gain factor and the time constant; and
a configuration module (804), configured to configure the dominant pole and the amplitude factor for a digital signal processing unit (14) comprised in the to-be-calibrated electronic transformer, so that the digital signal processing unit (14) performs digital filtering on an input signal based on the dominant pole and the amplitude factor, to obtain an output signal, wherein the input signal is obtained by performing analog-to-digital conversion on a signal output by the tested signal acquisition unit (12).

10. The apparatus according to claim 9, wherein the obtaining module (801) comprises:

an input submodule (8011), configured to input a test signal generated by a signal generation apparatus separately into the tested signal acquisition unit (12) and a reference signal acquisition unit;
a sampling submodule (8012), configured to sample the test signal at a plurality of different frequency points of the test signal via the tested signal acquisition unit (12) and the reference signal acquisition unit, to obtain a plurality of first sampled signals acquired by the tested signal acquisition unit (12) and a plurality of second sampled signals acquired by the reference signal acquisition unit; and
an operation submodule (8013), configured to determine, based on the first sampled signal and the second sampled signal that correspond to a same frequency point, an amplitude and a phase angle of the first sampled signal.

11. The apparatus according to claim 9, wherein
the first calculation module (802) is specifically configured to construct a target function according to a least squares method, and solve the target function to obtain the amplitude gain factor and the time constant of the tested signal acquisition unit (12), wherein a variable of the target function comprises the amplitude gain factor and the time constant of the tested signal acquisition unit (12), and a constant of the target function comprises the amplitudes and the phase angles of the sampled signals obtained by the tested signal acquisition unit (12) through sampling.

12. The apparatus according to claim 11, wherein the target function comprises:

$$y(T, M) = \sum_{k=1}^{N} \left| \frac{M}{1 + j2\pi f_k T} - A_k e^{j\theta_k} \right|^2,$$

wherein
N is used to represent a quantity of the frequency points, j is used to represent an imaginary number, $f_k$ is used to represent a frequency value corresponding to a $k^{th}$ frequency point, $A_k$ is used to represent an amplitude of a sampled signal obtained by the tested signal acquisition unit (12) by sampling the test signal at the $k^{th}$ frequency point, $\theta_k$ is used to represent a phase angle of the sampled signal obtained by the tested signal acquisition unit (12) by sampling the test signal at the $k^{th}$ frequency point, e is used to represent a natural constant, M is used to represent the amplitude gain factor, and T is used to represent the time constant.

13. The apparatus according to claim 9, wherein the second calculation module (803) comprises:

a first construction submodule (8031), configured to determine a cut-off frequency of a filter in the tested signal acquisition unit (12) based on the time constant;
a second calculation submodule (8032), configured to determine actual capacitance of a capacitor in the filter based on the cut-off frequency of the filter;
an analysis submodule (8033), configured to update a signal transmission model with the actual capacitance, and perform pole-zero analysis on the signal transmission model to obtain the dominant pole of the tested signal acquisition unit (12), wherein the signal transmission model is obtained by modeling an analog signal transmission system, the analog signal transmission system comprising an induction unit (11) and the tested signal acquisition unit (12) in the to-be-calibrated electronic transformer; and
a first transformation submodule (8034), configured to transform the amplitude gain factor to obtain the amplitude factor of the tested signal acquisition unit (12).

14. The apparatus according to any one of claims 9 to 13, wherein the configuration module (804) comprises:

a second construction submodule (8041), configured to construct an analog filter based on the dominant pole and the amplitude factor;
a second transformation submodule (8042), configured to perform bilinear transformation on the analog filter to obtain an intermediate digital filter; and
a conversion submodule (8043), configured to convert the intermediate digital filter into a difference equation to obtain a digital filter, wherein the digital filter is configured to perform digital filtering on the input signal to obtain the output signal,
wherein, the analog filter comprises:

$$H_{corr}(s) = \frac{1}{K} \cdot \frac{(s - p_{1\_new})}{(s - p_k)};$$

the intermediate digital filter comprises:

$$H_{corr}(z^{-1}) = \frac{1}{K} \cdot \frac{b_1 z^{-1} + b_0}{a_1 z^{-1} + 1};$$

and the digital filter comprises:

$$y[n] = \frac{1}{K} \cdot (b_0 \cdot x[n] + b_1 \cdot x[n-1]) - a_1 \cdot y[n-1],$$

wherein
$H_{corr}(s)$ is used to represent the analog filter, s is used to represent a complex frequency domain, $p_{1\_new}$ is used to represent the dominant pole, $p_k$ is used to represent a $k^{th}$ pole, and $K$ is used to represent the amplitude factor; and
$H_{corr}(z^{-1})$ is used to represent the intermediate digital filter, z is used to represent a zero,

$$b_1 = \frac{1 - 2f_s \cdot T_{1\_new}}{1 + 2f_s \cdot T_k} \cdot \frac{T_k}{T_{1\_new}}, \quad b_0 = \frac{1 + 2f_s \cdot T_{1\_new}}{1 + 2f_s \cdot T_k} \cdot \frac{T_k}{T_{1\_new}}, \quad a_1 = \frac{1 - 2f_s \cdot T_k}{1 + 2f_s \cdot T_k}, \quad T_{1\_new} = \frac{1}{|p_{1\_new}|}, \quad T_k \text{ is}$$

a constant, $f_s$ is a sampling frequency of the tested signal acquisition unit (12), y[n] is used to represent an output signal of the digital filter at a current sampling point, y[n - 1] is used to represent an output signal of the digital filter at a previous sampling point, *x[n]* is an input signal of the digital filter at the current sampling point, and *x[n - 1]* is an input signal of the digital filter at the previous sampling point.

15. A computer-readable storage medium, wherein the computer-readable storage medium has computer instructions stored thereon, and the computer instructions, when executed by a processor, cause the processor to perform the method according to any one of claims 1 to 8.

FIG. 1

200

201

202

203

204

FIG. 2

300

```
┌─────────────────────────────────┐
│              301                │
└─────────────────────────────────┘
                 │
                 ▼
┌─────────────────────────────────┐
│              302                │
└─────────────────────────────────┘
                 │
                 ▼
┌─────────────────────────────────┐
│              303                │
└─────────────────────────────────┘
```

FIG. 3

FIG. 4

FIG. 5

FIG. 6

700

| 701 |
|---|

↓

| 702 |
|---|

↓

| 703 |
|---|

FIG. 7

800

804

801 802 803

FIG. 8

FIG. 9

800

803

801

802

8031

8032

8033

804

8034

FIG. 10

800

804

802

803

8041

801

8042

8043

FIG. 11

1200

1201

1202

FIG. 12

Europäisches
Patentamt
European
Patent Office
Office européen
des brevets

**EUROPEAN SEARCH REPORT**

Application Number

EP 25 19 7680

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/243342 A1 (SIEMENS AG [DE]) 24 November 2022 (2022-11-24) | 1,4,6-9, 11,13-15 | INV. G01R23/16 |
| A | * pages 1-19 * | 2,3,5, 10,12 | G01R35/00 G01R31/62 |
| A | US 2019/383859 A1 (HURWITZ JONATHAN EPHRAIM DAVID [GB]) 19 December 2019 (2019-12-19) * the whole document * | 1-15 | |
| A | WO 2020/104794 A1 (SENTEC LTD [GB]) 28 May 2020 (2020-05-28) * the whole document * | 1-15 | |
| A | CN 107 167 757 A (ELECTRIC POWER RES INSTITUTE STATE GRID TIANJIN ELECTRIC POWER COMPANY) 15 September 2017 (2017-09-15) * the whole document * | 1-15 | |

TECHNICAL FIELDS
SEARCHED (IPC)

G01R

The present search report has been drawn up for all claims

| Place of search | Date of completion of the search | Examiner |
|---|---|---|
| Munich | 20 January 2026 | Kleiber, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 7680

This annex lists the patent family members relating to the patent documents cited in the above-mentioned European search report.
The members are as contained in the European Patent Office EDP file on
The European Patent Office is in no way liable for these particulars which are merely given for the purpose of information.

20-01-2026

| Patent document cited in search report | Publication date | Patent family member(s) | Publication date |
|---|---|---|---|
| WO 2022243342 A1 | 24-11-2022 | CN 115372876 A | 22-11-2022 |
| | | EP 4323776 A1 | 21-02-2024 |
| | | WO 2022243342 A1 | 24-11-2022 |
| US 2019383859 A1 | 19-12-2019 | NONE | |
| WO 2020104794 A1 | 28-05-2020 | AU 2019383717 A1 | 03-06-2021 |
| | | CA 3118572 A1 | 28-05-2020 |
| | | EP 3884285 A1 | 29-09-2021 |
| | | US 2022018878 A1 | 20-01-2022 |
| | | WO 2020104794 A1 | 28-05-2020 |
| CN 107167757 A | 15-09-2017 | NONE | |

EPO FORM P0459

For more details about this annex : see Official Journal of the European Patent Office, No. 12/82